# EUROPEAN PATENT APPLICATION

(11) **EP 1 881 588 A1**
(43) Date of publication of application: **23.01.2008**
(21) Application number: 06425495.6
(22) Date of filing: 19.07.2006
(51) Int. Cl.: H02M 3/07, G11C 5/14, G11C 16/30

(54) **Charge pump architecture and corresponding method for managing the voltage generation**

(71) Applicant: STMicroelectronics S.r.l., 20041 Agrate Brianza (Milano) (IT)
(72) Inventor: Conte, Antonino, 95030 Tremestieri Etneo (CT) (IT); Ucciardello, Carmelo, 95126 Catania (IT); D'Alessandro, Carmine, 95125 Catania (IT); Miccichè, Mario, 92100 Agrigento (IT); Matranga, Giovanni, 95126 Catania (IT); De Costantini, Diego, 96011 Augusta (SR) (IT)
(74) Representative: Ferrari, Barbara

(57) **Abstract**

A charge pump architecture (10) is described of the type comprising at least one first pump (11) for the generation of a first working voltage (VXR), a second pump (12) for the generation of a second working voltage (VYP) and a third pump (13) for the generation of a third working voltage (VNEG).
Advantageously according to the invention, the first pump (11) is connected to an internal supply voltage reference (Vdd) having limited value and has an output terminal (OUT1) connected to the second and third pumps (12,13) and supplying them with the first working voltage (VXR) as supply voltage.
A method is also described for managing the generation of voltages to be used together with the charge pump architecture (10) according to the invention.

## Description

### Field of application

The present invention relates to a charge pump architecture.

More specifically, the invention relates to a charge pump architecture of the type comprising at least one first pump for the generation of a first working voltage, a second pump for the generation of a second working voltage and a third pump for the generation of a third working voltage.

The invention also relates to a method for managing the voltage generation.

The invention particularly, but not exclusively, relates to a charge pump architecture for the generation of working voltages for a memory device, in particular of the Flash type, and the following description is made with reference to this field of application only for simplifying its illustration.

### Prior art

As it is well known, electrically erasable memory cells are nowadays widespread in several applications. Among these, Flash cells are of particular importance since they can be easily scaled with technologies that, for the future, will tend to channel lengths from 90nm and less.

In this context it becomes more and more important to succeed in integrating these types of Flash cells in standard CMOS technologies so as to obtain memories of the embedded type which are nowadays widely applied in several fields of the semiconductor market, such as SIM modules or memories for automotive applications.

When Flash memory cells are to be integrated in the recent 90nm CMOS technologies there arise problems linked to the needs, for low voltage transistors or LV transistors, of operating with lower and lower supply voltages. The voltages supplied externally on the other side do not scale in the same way but tend to remain rather high making it necessary the adoption of so called Voltage Down Converters.

If on one side these converters allow to separate an external supply reference from an internal one, on the other side, in correspondence with the current absorption peaks by, for example, an inner circuitry of a memory device, are subjected to inevitable losses or drops which can be in the order of some hundreds of mV. In this way, although using a converter suitable for regulating an internal supply voltage reference at a value being for example equal to 1.2V (typical working voltage for transistors realised in 90nm technologies), it is inevitable that, due to this drop phenomenon, minimum voltage values are in reality obtained which can also reach 1V.

All this implies significant difficulties in the design of memory devices, in particular of the Flash type, which normally need high operation voltages so as to modify and read the content of the corresponding memory cells.

Inside these memory devices of the Flash type a charge pump system is thus provided for the generation, starting from a single external supply voltage reference, of the internal voltage references necessary for the correct operation (reading, writing and erasing operations) of the Flash memory. This charge pump system is one of the analogue blocks of most difficult implementation and having to meet the following specifications:
1) minimum area occupation
2) reduced current consumptions
3) functionality just to very low supply voltage values
4) simultaneous generation of positive and negative voltage values with different regulation levels (in particular equal to +5V, +10V, -10V)

Further problems arise in particular applications providing wide external supply voltage ranges. This is the case, for example, of the Smart Card applications, where the range of external supply voltage is extremely wide (from 1.65V up to 5.5V).

In these applications, the design of the charge pump system, normally supplied directly with these external supply voltages, turns out to be extremely complicated exactly due to the wide range which impels to:
a) use, in any case, many charge pump stages (normally also indicated as pumping phases) inside this charge pump system, in cascade to each other and with pump capacitors of great capacity for meeting a lower limit of the external supply voltage range (normally equal to 1.65V)
b) insert some extremely big filter capacitors for reducing the ripple in correspondence with the high values of the external supply voltage range (normally equal to 5.5V)
c) entirely designing the charge pump system with high voltage transistors or HV transistors (the buffer stages of the charge pump stages included) with subsequent increase of the silicon area occupied by the system as a whole.

Normally, in Flash memories, it is necessary to generate at least three different regulation voltages so as to manage the operations of:
1) reading: in this case, the system of charge pump must take care of supplying a first reading voltage Vr (normally equal to +5V);
2) programming: in this case, the system of charge pumps must take care of simultaneously supplying a first Vp1 and a second programming voltage Vp2 (normally equal to +5V, +10V, -1V), the negative voltage value being in particular used for biasing, during a programming operation, the non selected wordlines;
3) erasing: in this case, the system of charge pumps must take care of simultaneously supplying a first Ve1 and a second erasing voltage Ve2 (normally equal to +10V, -10V).

Since the reading voltage is requested to be equal to the first programming voltage (Vr=Vp1) and the second programming voltage is requested to be equal to the first erasing voltage (Vp2=Ve1), the system of charge pumps will practically have to supply three working voltages, usually indicated with VXR, VYP and VNEG and having values equal to respectively +5V, +10V and -10V.

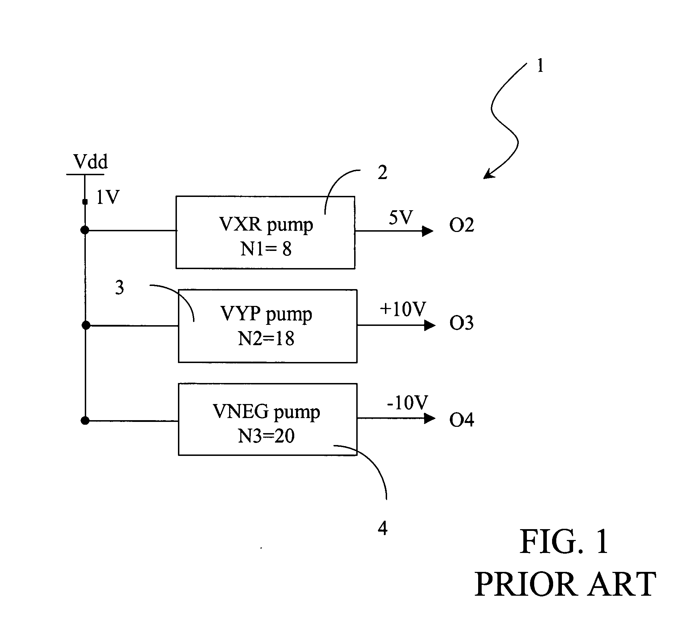

A system of charge pumps of the known type is schematically shown in Figure 1, globally indicated with 1.

The system 1 of charge pumps comprises, in particular, a first 2, a second 3 and a third pump 4, all supplied by a same internal supply voltage reference Vdd and suitable for supplying, on respective output terminals, 02-04, the above indicated working voltages. The pumps 2-4 are realised in a known way by means of the cascade of N charge pump stages.

It is possible to distinguish between the following cases:
a) the internal supply voltage Vdd is taken by means of a Voltage Down Converter and has a minimum voltage value equal to a minimum external supply voltage value (equal for example to 1.65V) further decreased by a fall or drop value (an inevitable drop being the Voltage Down Converter a non ideal element normally equal to ~200mV); in the indicated hypotheses, the internal supply voltage value Vdd is thus equal to ~1.45V
b) the internal supply voltage Vdd coincides with the one of the circuitry LV comprised in the Flash memory device and thus reaches a minimum value which can be also reduced below 1V.

In the case a) the three pumps 2, 3 and 4 of the system 1 should be completely realised with HV transistors with consequent large use of silicon area due to the used rules and to the lower efficiency of HV transistors with respect to LV transistors. Moreover, also the frequency of use will not be very high (~60MHz).

In the case b), the first 2 and the second pump 3 (i.e. the pumps generating positive voltages) can be realised by means of LV transistors and HV capacitors allowing to save area with respect to the case a), only the third pump 3 (i.e. the pump generating negative voltage) having to be realised with HV transistors and capacitors. However, considering the ratio between the working voltage to be generated (+/-10V) and the internal supply voltage Vdd (+1V), they should comprise a high number N of pump stages (about N3= 18 stages for the second pump 3 and up to N4=20 stages for the third pump 4, as indicated in the Figure, in the case of an internal supply voltage Vdd equal to 1V).

The technical problem underlying the present invention is that of providing a system of charge pumps for a memory device, in particular of the Flash type, having such structural and functional characteristics as to allow a reduced area occupation and a reduction of the consumptions of the system as a whole also in case of reduced internal supply voltage values, thus overcoming the limits and the drawbacks still affecting the systems realised according to the prior art.

### Summary of the invention

The solution idea underlying the present invention is that of connecting the pumps of the system of charge pumps in cascade to each other, so that only the first one is supplied by the internal supply voltage of limited value.

On the basis of this solution idea the technical problem is solved by a charge pump architecture as previously indicated and defined by the characterising part of claim 1.

The problem is also solved by a method for managing the generation of voltages defined by the characterising part of claim 13.

The characteristics and the advantages of the architecture and of the method according to the invention will be apparent from the following description of an embodiment thereof given by way of indicative and non limiting example with reference to the annexed drawings.

### Brief description of the drawings

In these drawings:
Figure 1 schematically shows a charge pump system realised according to the prior art;
Figure 2 schematically shows a charge pump architecture realised according to the invention;
Figure 3 shows in greater detail a particular of the architecture of Figure 2; and
Figures 4-7 show the pattern of signals relative to the charge pump architecture of Figure 2, obtained with a method for managing the voltage generation according to the invention.

### Detailed description

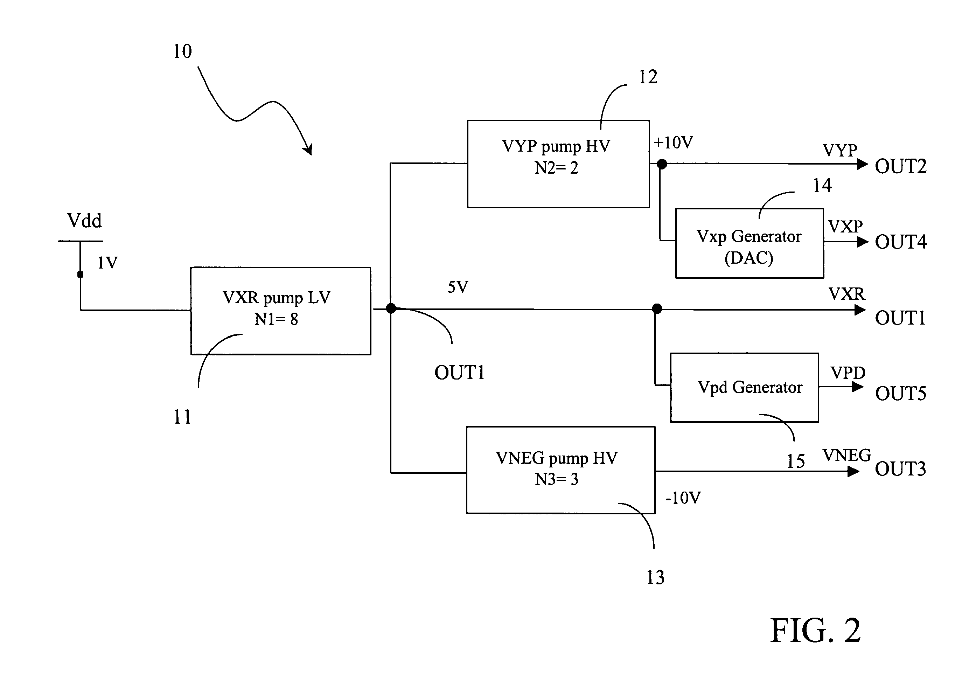

With reference to these figures, and in particular to Figure 2, a charge pump architecture is schematically shown, globally indicated with 10.

The charge pump architecture 10 comprises a first pump 11 connected to an internal supply voltage reference Vdd and supplied thereby and has an output terminal OUT1.

Advantageously according to the invention, a second 12 and a third pump 13 are connected to the output terminal OUT1 of the first pump 11 and supplied thereby and have respective output terminals, OUT2 and OUT3.

In particular, the output terminal OUT1 of the first pump 11 supplies a first working voltage VXR having a suitable value for being used for reading operations of a memory device, in particular of the Flash type, connected to the charge pump architecture 10 (not shown in the Figure), hereafter indicated as reading voltage VXR, the output terminal OUT2 of the second pump 12 supplies a second working voltage VYP having a suitable value for being used in programming operations of such memory device, hereafter indicated as programming voltage VYP, and the output terminal OUT3 of the third pump 13 supplies a third working voltage VNEG having a suitable value for being used for erasing operations of the memory device, hereafter indicated as erasing voltage VNEG.

In substance, the first pump 11 generates the supply voltage of the other two pumps, 11 and 12, which are given the task of generating the high positive and negative voltages involved in the programming and erasing operations.

Suitably, the charge pump architecture 10 also comprises a first generator 14 of a ramp voltage VXP and a second generator 15 of a drain voltage VPD for the memory cells of a device connected to the architecture 10 itself.

In particular, the first generator 14 is connected to the output terminal OUT2 of the second pump 12 and supplied thereby and comprises a DAC (Digital to Analog Converter) used for the generation of the ramp voltage VXP to be applied on the control or gate terminals of these memory cells. The first generator 14 has an output terminal OUT4 suitable for supplying this ramp voltage VXP.

In a similar way, the second generator 15 is connected to the output terminal OUT3 of the third pump 13 and supplied thereby and comprises an operational amplifier suitable for generating the drain voltage VPD to be applied to the drain terminals of the memory cells. The second generator 15 has an output terminal OUT5 suitable for supplying this drain voltage VPD.

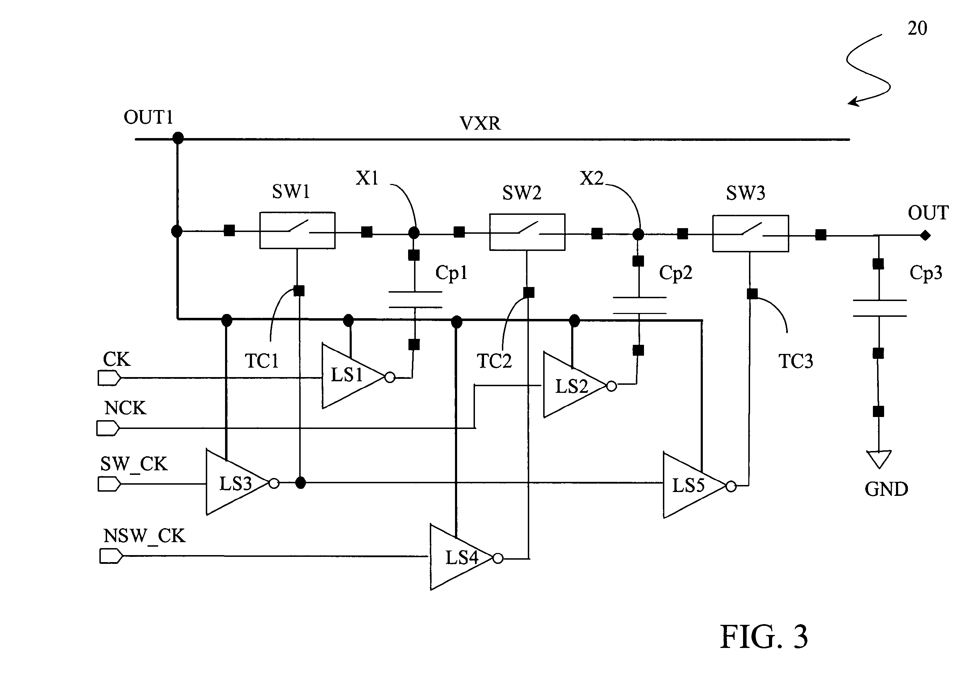

It is to be noted that, advantageously according to the invention, only the first pump 11 is realised with LV transistors and with a high number N1 of pump stages (for example N1=8), while the second and third pumps, 12 and 13, can be realised with HV transistors and with an extremely reduced number of stages, N2 and N3, in particular equal to N2=2 and N3=3, as reported in Figure 3.

In other words, the ratio between the first number N1 of pump stages and the second and third numbers of pump stages, N2 and N3, is higher or at the most equal to two.

Advantageously according to the invention, the pump stages comprised in the second and third pumps, 12 and 13, are in turn connected to the output terminal OUT1 of the first pump 11 and supplied thereby, as shown in Figure 3 where a three-phase pump stage has been shown, globally indicated with 20.

The pump stage 20 essentially comprises a first, a second and a third pump capacity, Cp1-Cp3, connected to the terminal OUT1, indicated hereafter as supply reference OUT1 through respective switches SW1-SW3 and a plurality of buffer stages LS1-LS5 connected to these pump capacities, Cp1-Cp3, to such switches SW1-SW3 and to a plurality of clock inputs, CK, NCK, SW_CK, NSW_CK. The buffer stages LS1-LS5 are all connected to the supply reference OUT1 and supplied thereby.

More in detail, the first pump capacity Cp1 is connected to a first inner circuit node X1 in turn connected to the supply reference OUT1 through the first switch SW1, as well as to a first clock input CK through a first buffer stage LS 1.

The second pump capacity Cp2 is connected to a second inner circuit node X2 in turn connected to the first inner circuit node X1 through the second switch SW2, as well as to a second clock input NCK.

Furthermore, the third pump capacity Cp3 is connected between an output terminal OUT and a further voltage reference, in particular the ground GND, this output terminal OUT being in turn connected to the second inner circuit node X2 through the third switch SW3.

The switches SW1-SW3 are also driven in correspondence with respective driving terminals TC1-TC3 through respective third LS3, fourth LS4 and fifth LS5 buffer stages. In particular, the third buffer stage LS3 is connected at the input to a third clock input SW_CK and at the output to the driving terminal TC1 of the first switch SW1, the fourth buffer stage LS4 is connected at the input to a fourth clock input NSW_CK and at the output to the driving terminal TC2 of the second switch SW2 and the fifth buffer stage LS5 is connected at the input to the output of the third buffer stage LS3 and at the output to the driving terminal TC3 of the third switch SW3.

Suitably, these first and second clock inputs, CK e NCK, receive a first and a second clock signal, for simplicity indicated also as CK and NCK, which are complementary to each other. Similarly, this third and fourth clock input, SW_CK and NSW_CK, receive a third and a fourth clock signal, for simplicity also indicated as SW_CK and NSW_CK, which are complementary to each other.

It is to be noted that, thanks to the supply carried out with the voltage value output from the first pump 11, the buffer stages LS1-LS5 of the pump stage 20 are realised in reality as simple level shifters, the whole charge pump architecture 10 thus having an extremely reduced area.

It is however to be underlined that the charge pump architecture 10 has some constraints to be respected for its correct operation:
1) the first pump 11 should be sized so as to sustain a current value equal to that simultaneously requested by the second and by the third pump 13 (both HV pumps) placed downstream of this first pump 11;
2) the charge pump architecture 10 has a rather high mean and peak consumption and an over-sizing on the Down Converter side is thus to be provided, such side having to supply all the current requested by the whole architecture, in case of use of the same for the generation of the working voltages necessary for the reading and modify (programming/erasing) operations of a memory device connected to this charge pump architecture 10.

Advantageously according to the invention, a method is thus proposed for managing the generation of voltages to be used for the charge pump architecture 10 and able to minimise the above indicated consumptions.

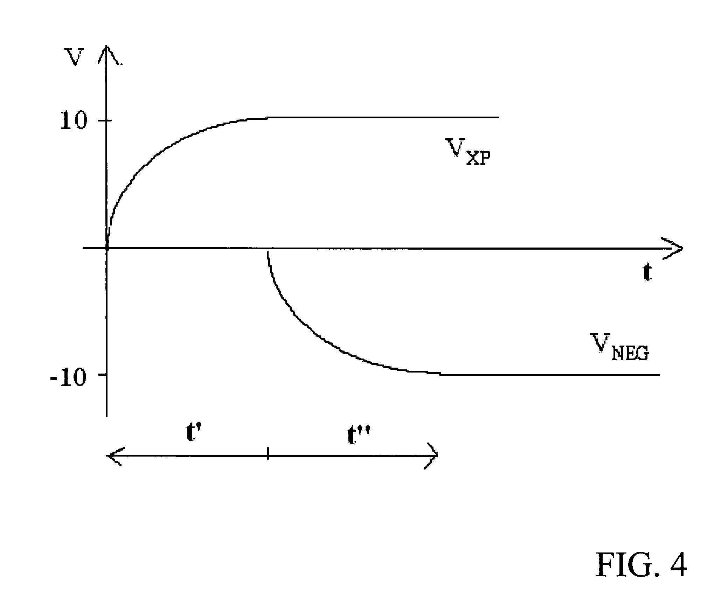

In particular, the method for managing the generation of voltages according to the invention essentially controls the generation steps of the programming and erasing voltages so as not to simultaneously overlap the consumption of the corresponding pumps, 12 and 13, downstream of the first pump 11 in a same time range, as schematically indicated in Figure 4.

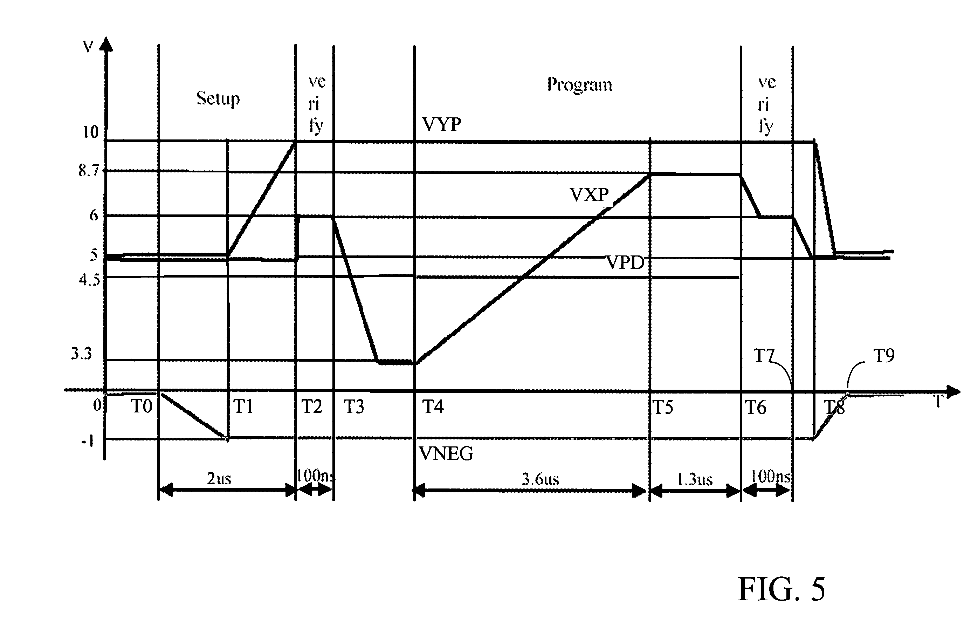

More in detail, making particular reference to Figure 5, it is possible to point out the various critical moments for the consumption of the charge pump architecture 10 used for generating the programming and erasing voltage of a memory device, for example of the Flash type. In this way, it is to be considered that the steps of greater consumption of these pumps are the setup steps, when the voltage values supplied by the pump change level.

To better understand the method according to the invention, first of all a programming operation is considered [Program].

In an initial step [Setup], the third pump 13 suitable for supplying the negative voltage value, the erasing voltage VNEG (in particular equal to -1V) which is used for biasing the word lines which are not selected in programming and inhibiting possible program disturbances on the erased cells, is activated (instant T0).

In this step, advantageously according to the invention, the second pump 12 suitable for supplying the voltage programming value VYP, is not brought to the highest level (in particular equal to +10V), and remains latched (until the instant T1) to the supply voltage value at the output terminal OUT1 of the first pump 11, i.e. the reading voltage VXR (in particular equal to +5V).

In other words, the method for managing the generation of voltages according to the invention comprises a step of turn-on phase shift of the second and of the third pump, 12 and 13, so that the second pump 12 is turned on only when the output terminal OUT3 of the third pump 13 has reached a requested voltage level. In particular, in case of a programming step, the second pump 12 of the programming voltage VYP is turned on only in the instant T1 when the third pump 13 supplies on its output terminal OUT3 an erasing voltage VNEG having a value which is equal to -1V, as shown in the Figure.

In this way, the method comprises a setup of the pumps divided into two different steps:
- turn on of the third pump 13: from T0 to T1 with the erasing voltage VNEG at the output terminal OUT3 of this pump which reaches the value of -1V; and
- turn on of the second pump 12: from T1 to T2 with the programming voltage VYP at the terminal OUT2 of this pump which passes from a value equal to +5V (i.e. the value of the reading voltage VXR, supply voltage for this pump), to a desired value for the programming, i.e. +10V.

More in particular, advantageously according to the invention, this step of turn-on phase shift thus comprises a latching step (latching period =T1-T0), in which the second pump 12 is maintained latched to the output terminal OUT1 of the first pump 11, which should thus supply current only to the third pump 13 for the generation of the erasing voltage VNEG.

Subsequently, the method provides an activation step of the second pump 12 for the generation of the high positive voltage value, i.e. the programming voltage VYP which, as seen, will reach, with its own rise time Trise=T2-T1, from an initial value equal to its supply VXR (+5V), a final desired level (+10V) so as to allow the suitable biasing of the memory cell for the column decoding (i.e. +10V).

In this way, advantageously according to the invention, the method allows to reduce the consumptions of the charge pump architecture 10 which depend in the first step of the setup only by the third pump 13 which reaches -1V (the second pump 12 being latched to VXR) and in the second setup step only by the second pump 12 which goes from +5V to +10V (the third pump 13 remaining at-1V).

The method then provides, in a known way:
- a first verify step of the cells to be programmed (period from T2 to T3) wherein the programming voltage VYP and the erasing voltage VNEG remain at the values taken in the previous setup step, while the ramp voltage VXP reaches a reading value (equal to +6V), this programming verify step being in fact a real reading step;
- a transition step (period from T3 to T4) in which the ramp voltage VXP reaches again a verify value (equal to +3.3V); and
- a real programming step (period from T4 to T5) in which the ramp voltage VXP reaches a programming value (equal to +8.7V) through the turn on of the first generator 14; in this step, also the second generator 15 generates the drain voltage VPD and supplies a current directly to the memory cells to be programmed.

The ramp voltage VXP raises with a controlled slope up to a value suitably lower than the value of the programming voltage VYP.

The method then comprises a so called plateau step (period from T5 to T6) in which the ramp voltage VXP maintains the value taken in the previous step (equal to +8.7V) followed by a verify step of the programmed cells (period from T6 to T7) and by a discharge or output step (period from T7 to T8), these steps not implying consumptions for the charge pump architecture 10.

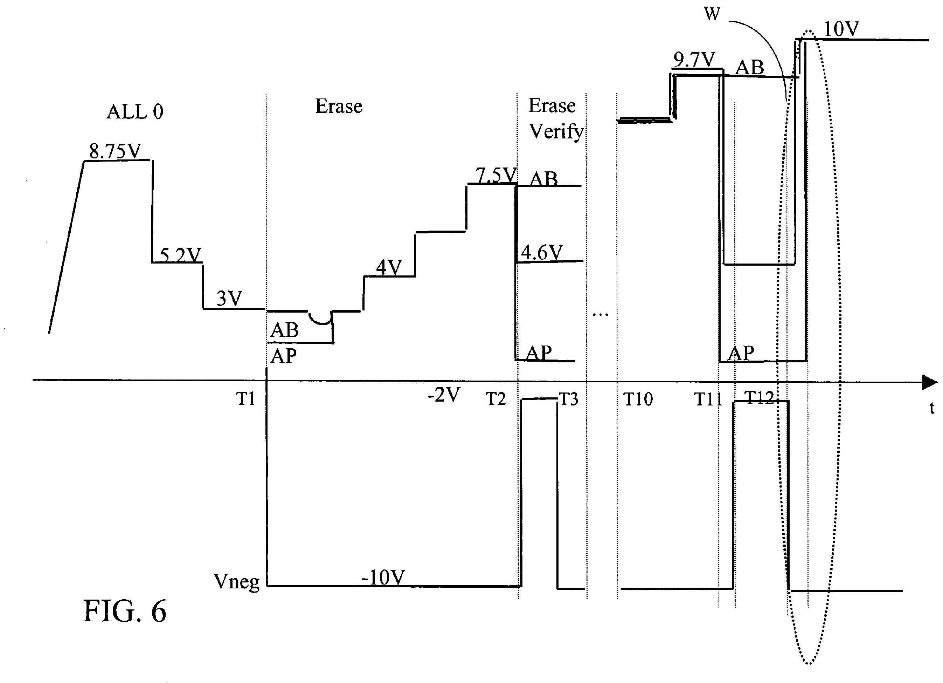

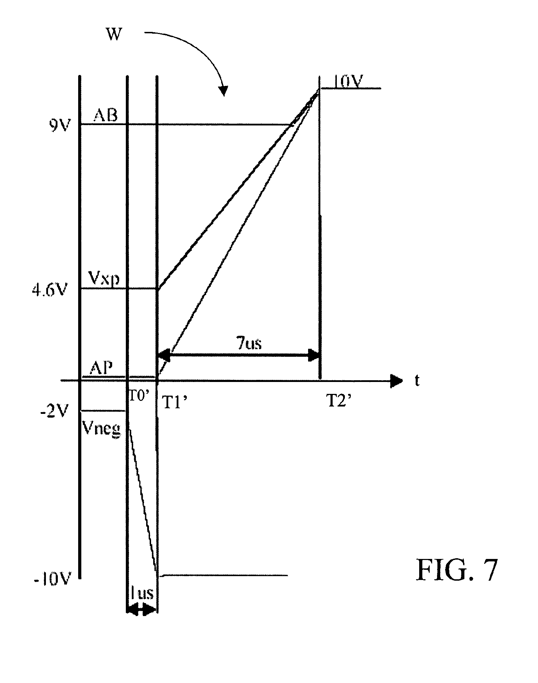

Making now reference in particular to Figures 6 and 7, an erasing operation is considered.

It is to be underlined that in this case the method provides a management of the generation of the erasing voltage VNEG and of the ramp voltage VXP, this latter being however responsible for the consumptions of the charge pump architecture 10 since it is obtained through the first generator 14 supplied by the programming voltage VYP generated by the second pump 12. The programming voltage VYP is instead maintained fixed at a value equal to +10V.

In particular, as shown in Figure 6, an erasing operation comprises a first step so called ALLO (up to T1) in which all the cells are programmed at the value 0 with a step-like ramp voltage VXP followed by a real erasing step [Erase] which comprises a setup of the third pump 13 for the generation of the erasing voltage VNEG and of the first generator 14 for the generation of the ramp voltage VXP, with subsequent activation of the second pump 12 which supplies this first generator 14 with the voltage VYP as supply voltage.

In this erasing step a first voltage AB and a second voltage AP are generated to be respectively applied to the P wells which contain all the cells of a memory sector and to an N well which comprises these P wells also of different sectors. These first and second voltages, AB and AP, are brought to an initial value equal to about 3V up to a final erasing value equal to 7.5V.

In a known way, an erase verify step [Erase Verify] follows in which the first voltage AB is maintained at a value reached in the previous step, being equal to 7.5B, the second voltage AP is brought again to the value it had at the end of the previous step of ALLO and the ramp voltage VXP is brought to a reading level being equal to 4.6V, this erasing verify step being in fact a real reading step.

The erasing and verify steps are repeated with raising of the final value reached by the voltages AB, AP and VXP.

Under the worst conditions (indicated in Figure 6 with W and shown in greater detail in Figure 7), this final value is equal to the maximum positive voltage value, i.e. +10V and it will correspond to the maximum consumption of current by the charge pump architecture 10.

Also in this erasing operation, advantageously according to the invention, the method comprises a step of turn on phase shift of the second and of the third pump, 12 and 13, for which the first generator 14 of the ramp voltage VXP (which is supplied by the second pump 12) is turned on only when the output terminal OUT3 of the third pump 13 has been brought to a required voltage level. In particular, in case of an erasing step, the first generator 14 of the ramp voltage VXP is turned on only in the instant T1' when the third pump 13 supplies its output terminal OUT3 with an erasing voltage VNEG having a value which is equal to-10V.

In this way, the method comprises a setup divided into two distinct steps:
- turn on of the third pump 13: from T0' to T1' with the erasing voltage VNEG at the output terminal OUT3 of this pump which is brought to the value of -10V; and
- turn on of the first generator 14 (and subsequently of the second pump 12): from T1' to T2' with the ramp voltage VXP at the terminal OUT4 of this first generator 14 which passes from a value equal to +4.6V (i.e. the reading value of the previous erase verify step), to a desired value for the erasing, i.e. -10V.

In this way, advantageously according to the invention, the method allows to reduce the consumptions of the charge pump architecture 10 which depend in the first step of the setup only on the third pump 13 which is brought to -10V (the second pump 12 not having to supply current to the first generator 14) and in the second step of the setup only on the first generator 14 which generates a ramp voltage VXP which passes from 4.6V to 10V and requires current from the second pump 12 which supplies it (the third pump 13 remaining at -10V).

Advantageously according to the invention, the method for managing the generation of the voltage provides a control of the erasing pulses for minimising the consumption of the pumps comprised in the charge pump architecture 10.

In this way, the method for managing the generation of voltages applied to the charge pump architecture 10 according to the invention prevents a simultaneous consumption by the pumps 12 and 13 which supply the programming voltage VYP and the erasing voltage VNE and regulate the generation of the ramp voltage VXP.

Advantageously, the consumption of current is thus limited for the first pump 11 and thus it allows to calibrate its sizing on the driving capability requested by the cells of the memory device connected to the charge pump architecture 10 which, in case of a memory of the Flash type, should be programmed in parallel.

It is to be noted that the method for managing the generation of voltages according to the invention introduces an additional time requested for avoiding the overlapping of the consumptions, but increases, in a non appreciable way, the duration of the programming and erasing times.

In conclusion, the charge pump architecture according to the invention allows to make the silicon area consumption minimum and to contain the pump current consumption, in particular of the first pump 11.

Its application is thus particularly advantageous in devices where the generation of the high voltages is necessary starting not from an external voltage reference but from an internal voltage reference regulated by a Down Converter or however where the supply voltages are extremely low (1V or below).

Together with the managing method according to the invention, it is possible to obtain the generation of the voltages required by the programming, erasing and also reading operations, with a single pump supplied by the inner voltage reference and suitably connected to the other two pumps of extremely contained sizes (for the generation of the programming voltage VYP and of the erasing voltage VNEG). Advantageously, these further pumps can be realised with a minimum number of stages (2 and 3 respectively in the example shown), reducing the silicon area requested for the realisation of the whole charge pump architecture to the minimum.

## Claims

1. Charge pump architecture (10) of the type comprising at least one first pump (11) for the generation of a first working voltage (VXR), a second pump (12) for the generation of a second working voltage (VYP) and a third pump (13) for the generation of a third working voltage (VNEG) **characterised in that** said first pump (11) is connected to an internal supply voltage reference (Vdd) having limited value and has an output terminal (OUT1) connected to said second and third pumps (12, 13) and supplying them with said first working voltage (VXR) as supply voltage.

2. Charge pump architecture (10) according to claim 1, **characterised in that** said first pump (11) is realised with low voltage transistors and with a first number (N1) of pump stages.

3. Charge pump architecture (10) according to claim 2, **characterised in that** said second and third pumps (12, 13) are realised with high voltage transistors and with a second and a third number (N2, N3) of pump stages, respectively, said second and third numbers (N2, N3) of pump stages being smaller than said first number (N1) of pump stages.

4. Charge pump architecture (10) according to claim 3, **characterised in that** the ratio between said first number (N1) of pump stages and said second and third numbers (N2, N3) of pump stages is greater or equal to two.

5. Charge pump architecture (10) according to claim 1, **characterised in that** it further comprises a first generator (14) of a third working voltage (VXP) connected to an output terminal (OUT2) of said second pump (12) and supplied thereby.

6. Charge pump architecture (10) according to claim 5, **characterised in that** said first generator (14) comprises a DAC [Digital to Analog Converter].

7. Charge pump architecture (10) according to claim 5, **characterised in that** it further comprises a second generator (15) of a fourth working voltage (VPD) connected to an output terminal (OUT3) of said third pump (13) and supplied thereby.

8. Charge pump architecture (10) according to claim 7, **characterised in that** said second generator (15) comprises an operational amplifier.

9. Charge pump architecture (10) according to any of the preceding claims, used for the generation of working voltages for a memory device, **characterised in that** said first working voltage (VXR) has a value suitable for being used for reading operations of said memory device, said second working voltage (VYP) has a value suitable for being used for programming operations of said memory device and said third working voltage (NEG) has a value suitable for being used for erasing operations of said memory device.

10. Charge pump circuit (10) according to claim 9, **characterised in that** said first working voltage (VXR) has a positive voltage value, said second working voltage (VYP) has a positive high voltage value and said third working voltage (NEG) has a negative high voltage value.

11. Charge pump circuit (10) according to claim 10, **characterised in that** said first working voltage (VXR) has a value equal to +5V, said second working voltage (VYP) has a value equal to +10V and said third working voltage (NEG) has a value equal to -10V.

12. Charge pump circuit (10) according to claim 9, **characterised in that** said second and third pumps (12, 13) comprise a plurality of pump stages (20) connected in parallel with each other to said output terminal (OUT1) of said first pump (11) and supplied thereby, each pump stage (20) comprising a plurality of pump capacities (Cp1-Cp3) connected to said output terminal (OUT1) by means of respective switches (SW1-SW3) and a plurality of buffer stages (LS1-LS5) connected to said pump capacities (Cp1-Cp3), to said switches (SW1-SW3) and to a plurality of clock inputs (CK, NCK, SW_CK, NSW_CK) as well as to said output terminal (OUT1) they are supplied by, said buffer stages (LS1-LS5) comprising level shifters.

13. Method for managing the generation of voltages for a charge pump architecture (10) according to any claim 1 to 12, **characterised in that** it controls the generation steps of said second and third working voltages (VYP, VNEG) so as not to overlap the turn-on of said first and second pumps (12, 13).

14. Method for managing the generation of voltages according to claim 13, **characterised in that** it comprises a setup step with turn-on phase shift of said second and third pump (12, 13), so that said second pump (12) is turned on only when said output terminal (OUT3) of said third pump (13) has reached a requested voltage level.

15. Method for managing the generation of voltages according to claim 14, **characterised in that** said setup step is divided into two different steps:
- turn-on of said third pump (13) for the generation of said erasing voltage (VNEG) on said output terminal (OUT3) of said third pump (13) up to said requested voltage level; and
- turn-on of said second pump (12) for the generation of said second working voltage (VYP) on said output terminal (OUT2) of said second pump (12) up to a desired value for an operation of a memory device connected to said charge pump architecture (10).

16. Method for managing the generation of voltages according to claim 15, **characterised in that**, for a programming operation of said memory device, said second pump (12) is latched to said voltage value of said output terminal (OUT1) of said first pump (11) until said third working voltage (VNEG) reaches a desired value for said programming operation and **in that** said second pump (12) is then turned on until said second working voltage (VYP) reaches said desired value for said programming operation.

17. Method for managing the generation of voltages according to claim 15, **characterised in that**, for an erasing operation of said memory device, said first generator (14) of said ramp voltage (VXP) is maintained at a reading value until said third working voltage (VNEG) reaches a desired value for said erasing operation and is then turned on until said ramp voltage (VXP) reaches a desired value for said erasing operation and said second pump (12) is turned on for supplying said first generator (14).
